# EUROPEAN PATENT APPLICATION

(11) **EP 4 741 528 A1**
(43) Date of publication of application: **13.05.2026**
(21) Application number: 25208904.0
(22) Date of filing: 15.10.2025
(51) Int. Cl.: C23C 16/448, C23C 16/455

(54) **SEMICONDUCTOR PROCESSING APPARATUS**

(30) Priority: 18.10.2024 US 202463709212 P
(71) Applicant: ASM IP Holding B.V., 1322 AP Almere (NL)
(72) Inventor: JDIRA, Lucian, 1322 AP Almere (NL); BANKRAS, Radko, 1322 AP Almere (NL); YUKANANTO, Riza, 1322 AP Almere (NL); PROSERPIO, Davide, 1322 AP Almere (NL); TERHORST, Herbert, 1322 AP Almere (NL); OOSTERLAKEN, Theodorus G.M., 1322 AP Almere (NL); VAN HAASTERT, Simon, 1322 AP Almere (NL); JONGBLOED, Bert, 1322 AP Almere (NL); KNAEPEN, Werner, 1322 AP Almere (NL); TRABELSI, Fatma, 1322 AP Almere (NL)
(74) Representative: V.O.

(57) **Abstract**

A semiconductor processing apparatus is disclosed. The semiconductor processing apparatus comprises a process chamber configured to receive a plurality of substrates; an accumulator vessel in fluid communication with the process chamber, configured to store a precursor in gas form; and at least two solid state precursor storage vessels, each being configured to receive a precursor in gas form, to cause said received gas form precursor to be converted to a solid state inside the respective solid state precursor storage vessel, and to cause said solid state precursor to be converted to gas phase. Each of the at least two solid state precursor storage vessels are in fluid communication with the accumulator vessel.

## Description

### FIELD

The present disclosure relates generally to the field of semiconductor processing methods, and associated structures and apparatus, and to the field of device and integrated circuit manufacture. More particularly the present disclosure generally relates to semiconductor processing apparatus in which precursor may be stored in the solid state.

### BACKGROUND

In the field of semiconductor manufacturing apparatus, batch processing apparatuses, for example vertical furnaces, may provide a significant increase in throughput as compared with single wafer tools which generally process wafers one by one.

However, the amount of precursor required to be provided to a reactor chamber or process chamber of a vertical furnace in order to form a layer of a required thickness on each of a plurality of wafers, or substrates, contained therein, is significantly greater than the amount required to be provided to a reactor chamber of a single wafer tool to form a layer of the same required thickness. Further, in order to provide for example an acceptable throughput and/or a required precursor pressure in the process chamber, the required quantity of precursor may need to be provided within a specific, short time span.

Some precursors, for example ammonia, can be stored in gas form for long periods of time without decomposition. Storage in gas form enables fast and reliable delivery of precursor. Supply of such precursors to the process chamber is relatively straightforward as the required amount of gas can be flowed from a sub-fab supply. Other precursors may decompose when stored in gas form, especially if they are required to be stored at a particular temperature to avoid deposition on surfaces of a container in which a precursor gas is contained, rendering them no longer suitable for use in a deposition process. For such precursors, alternative solutions are needed.

There is a need for apparatus and methods capable of supplying large amounts of gas phase precursor on demand and with high flow rate.

Any discussion, including discussion of problems and solutions, set forth in this section, has been included in this disclosure solely for the purpose of providing a context for the present disclosure, and should not be taken as an admission that any or all of the discussion was known at the time the invention was made or otherwise constitutes prior art.

### BRIEF SUMMARY

This summary introduces a selection of concepts in a simplified form, which are described in further detail below. This summary is not intended to necessarily identify key features or essential features of the claimed subject matter, nor is it intended to be used to limit the scope of the claimed subject matter.

According to a first aspect of the present invention, there is provided a semiconductor processing apparatus comprising a process chamber configured to receive a plurality of substrates, an accumulator vessel in fluid communication with the process chamber, the accumulator vessel being configured to store a precursor in gas form, and at least two solid state precursor storage vessels, each being configured to receive a precursor in gas form, to cause said received gas form precursor to be converted to a solid state inside the respective solid state precursor storage vessel, and to cause said solid state precursor to be converted to gas phase. Each of the at least two solid state precursor storage vessels are in fluid communication with the accumulator vessel so as to allow provision of precursor in gas form to the accumulator vessel.

Providing the precursor to the solid state precursor storage vessels in gas form may have advantages over provision in liquid or powder form. Provision of the precursor in liquid form, for example being dissolved or otherwise carried by a solvent, to a precursor storage vessel followed by evaporation of the solvent in the vessel requires an additional drying step in the process of (re) filling the precursor storage vessel, may result in solvent contamination of the precursor to be extracted from the vessel, and may be limited in capacity, thus limiting the number of substrates which can be processes, impacting throughput. Providing the precursor in powder form may causing clogging and a carrier gas may be required in order to remove precursor from the vessel.

By providing at least two solid state precursor storage vessels, one of the solid state precursor storage vessels may receive and store precursor while another of the solid state precursor storage vessels may supply precursor to the accumulator vessel, allowing for continuous supply of precursor gas to the accumulator vessel.

By providing the accumulator vessel for short-term storage of precursor gas close to the process chamber, high doses of precursor can be collected and provided to the process chamber in a shorter time period than would be needed for the same amount of precursor gas to be sublimated, allowing for faster provision of precursor to the process chamber and therefore increased throughput.

Each of the at least two solid state precursor storage vessels may be in fluid communication with a bulk precursor supply for providing a precursor in gas form.

Providing a fluid communication with a bulk precursor supply allows the at least two solid state precursor storage vessels to be refilled with precursor gas without requiring their removal from the semiconductor processing apparatus, allowing for long uptime of the semiconductor processing apparatus and consequently increased throughput.

Each of the at least two solid state precursor storage vessels may include a respective heater.

Each of the at least two solid state precursor storage vessels may include a respective gas inlet port configured to conduct a precursor in gas form into the respective solid state precursor storage vessel.

The semiconductor processing apparatus may include a first gas line for providing a fluidic connection between a first solid state precursor storage vessel of the at least two solid state precursor storage vessels and the accumulator vessel; and a second gas line for providing a fluidic connection between a second of the at least two solid state precursor storage vessels and the accumulator vessel.

The semiconductor processing apparatus may comprise a first gas flow control valve disposed in the first gas line and a second gas flow control valve in the second gas line. The semiconductor processing apparatus may comprise a controller configured to cause the first gas flow control valve to be set to a closed state while substantially simultaneously causing the second gas flow control valve to be set to an open state.

The semiconductor processing apparatus may include a third gas line for providing a fluidic connection between a bulk precursor supply for providing a precursor in gas form and a first of the at least two solid state precursor storage vessels, and a fourth gas line for providing a fluidic connection between the bulk precursor supply and a second of the at least two solid state precursor storage vessels.

The semiconductor processing apparatus may comprise a third gas flow control valve disposed in the third gas line and a fourth gas flow control valve in the fourth gas line. The semiconductor processing apparatus may comprise a controller configured to cause the third gas flow control valve to be set to an open state while substantially simultaneously causing the fourth gas flow control valve to be set to a closed state.

The semiconductor processing apparatus may comprise a third gas flow control valve heater for heating the third gas flow control valve and a fourth gas flow control valve heater for heating the fourth gas flow control valve.

The semiconductor processing apparatus may include an enclosure for enclosing at least a part of the semiconductor processing apparatus located between the bulk precursor supply and the process chamber, and an enclosure heater for heating an interior of the enclosure.

The enclosure may enclose at least one gas flow control valve. The gas lines may be substantially located outside the enclosure.

The enclosure may enclose at least one gas line. The enclosure may enclose at least the accumulator vessel and the at least two solid state precursor storage vessels.

The enclosure may enclose at least one gas flow control valve. The enclosure may enclose one or more of the first, second, third, fourth, fifth, and sixth gas flow control valves. The respective gas lines in fluid communication with the one or more gas flow control valves enclosed by the enclosure may be located outside of the enclosure and may be heated using heating jackets.

The accumulator vessel may include an accumulator vessel heater.

The semiconductor processing apparatus may include a fifth gas flow control valve disposed upstream of the accumulator vessel and configured to control a gas flow into the accumulator vessel from any of the at least two solid state precursor storage vessels.

The semiconductor processing apparatus may include a sixth gas flow control valve disposed downstream of the accumulator vessel and configured to control a gas flow from the accumulator vessel into the process chamber.

The semiconductor processing apparatus may comprise a fifth gas flow control valve heater. The semiconductor processing apparatus may comprise a sixth gas flow control valve heater.

Each of the at least two solid state precursor storage vessels may comprise a first heater for heating a section of the respective solid state precursor storage vessel close to the respective gas inlet port and a second heater for heating a section of the respective solid state precursor storage vessel further from the respective gas inlet port.

By allowing independent control of the temperature of different sections of a solid state precursor storage vessel, deposition of precursor at or near the gas inlet port and/or the gas outlet port can be reduced or avoided during sublimation of solid state precursor contained in the solid state precursor storage vessel.

The semiconductor processing apparatus may comprise more than one accumulator vessel, each accumulator vessel being configured to receive precursor gas from at least one of the at least two solid state precursor storage vessels and to provide precursor gas to the process chamber. The more than one accumulator vessels may be connected in parallel such that each accumulator vessel can independently supply precursor gas to the process chamber.

According to a second aspect of the present invention there is provided a method of forming a layer on a plurality of substrates using the semiconductor processing apparatus. The method may include the steps of causing the first solid state precursor storage vessel to receive gas precursor from the bulk precursor supply while supplying precursor from the second solid state precursor storage vessel to the accumulator vessel, providing precursor from the accumulator vessel to the process chamber while causing the first solid state precursor storage vessel to receive gas precursor from the bulk precursor supply, providing a purge gas to the process chamber while causing the first solid state precursor storage vessel to receive gas precursor from the bulk precursor supply and causing the second solid state precursor storage vessel to provide gas precursor to the accumulator vessel, providing a second process gas to the process chamber while causing the first solid state precursor storage vessel to receive gas precursor from the bulk precursor supply and causing the second solid state precursor storage vessel to provide gas precursor to the accumulator vessel, and providing a purge gas to the process chamber while causing the first solid state precursor storage vessel to receive gas precursor from the bulk precursor supply and causing the second solid state precursor storage vessel to provide gas precursor to the accumulator vessel.

According to a third aspect of the present invention there is provided a method of providing a precursor gas to a process chamber of a semiconductor processing apparatus, the semiconductor processing apparatus including a process chamber configured to receive a plurality of substrates; an accumulator vessel in fluid communication with the process chamber, configured to store a precursor in gas form; at least two solid state precursor storage vessels, each being configured to receive a precursor in gas form, to cause said received gas form precursor to be converted to a solid state inside the respective solid state precursor storage vessel, and to cause said solid state precursor to be converted to gas phase, each of the at least two solid state precursor storage vessels are in fluid communication with the accumulator vessel so as to allow provision of gas phase precursor to the accumulator vessel. The method includes the steps of i) causing a first solid state precursor storage vessel of the at least two solid state precursor storage vessels to receive a precursor in gas form and to convert said precursor to a solid state, ii) causing a second solid state precursor storage vessel of the at least two solid state precursor storage vessels to convert solid state precursor to gas form and to provide precursor in gas form to the accumulator vessel, and iii) causing a precursor gas to be provided to the process chamber from the accumulator vessel.

Steps i) and ii) may be performed substantially simultaneously. Steps ii) and step iii) may not overlap substantially in time. The method may comprise, after step iii), causing the second solid state precursor storage vessel to receive a precursor in gas form and to convert said precursor to a solid state, and causing the first solid state precursor storage vessel to convert solid state precursor to gas form and to provide precursor in gas form to the accumulator vessel.

Causing a solid state precursor storage vessel to receive a precursor in gas form may comprise causing a bulk precursor supply to provide the precursor in gas form to the solid state precursor storage vessel. Causing a solid state precursor storage vessel to convert a precursor in gas form to solid state may include causing a part of the solid state precursor storage vessel to be cooled to a temperature below a deposition temperature of the precursor. Causing a solid state precursor storage vessel to convert solid state precursor to gas form may include causing a part of the solid state precursor storage vessel to be heated to a temperature above a sublimation temperature of the precursor.

The accumulator vessel may include a pressure transducer and a thermocouple, and step iii) may comprise determining an amount of precursor provided to the reactor based on data received from the pressure transducer and thermocouple. Step iii) may comprise closing an input port of the accumulator vessel so that no further precursor gas is provided to the accumulator vessel while precursor gas is supplied to the process chamber. Step iii) may comprise leaving open an input port of the accumulator vessel so that precursor gas is provided to the accumulator vessel while precursor gas is supplied to the process chamber.

Other technical features may be readily apparent to one skilled in the art from the following figures, descriptions, and claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

### BRIEF DESCRIPTION OF THE DRAWINGS

Certain embodiments of the present invention will now be described, by way of example, with reference to the accompanying drawings, in which:
FIG. 1 is a schematic view of a semiconductor processing apparatus according to embodiments of the present invention.
FIG. 2 is a schematic view of a semiconductor processing apparatus according to embodiments of the present invention comprising an enclosure and heater.
FIG. 3 is a schematic cross-sectional view of a solid state precursor storage vessel which may be comprised in a semiconductor processing apparatus according to embodiments of the present invention.
FIG. 4 is a schematic cross-sectional view of a process chamber which may be comprised in a semiconductor processing apparatus according to embodiments of the present invention.
FIG. 5 is a flow chart of a method according to embodiments of the present invention.
FIG. 6 illustrates valve states of a semiconductor processing apparatus at certain stages of a method according to embodiments of the present invention.
FIG. 7 illustrates valve states of a semiconductor processing apparatus at certain stages of a method according to embodiments of the present invention.
FIG. 8 is a schematic view of a semiconductor processing apparatus according to embodiments of the present invention with dose determination functionality.
FIG. 9 is a flow chart of a deposition method according to embodiments of the present invention.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION

The description of exemplary embodiments of methods and compositions provided below is merely exemplary and is intended for purposes of illustration only. The following description is not intended to limit the scope of the disclosure or the claims. Moreover, recitation of multiple embodiments having indicated features or steps is not intended to exclude other embodiments having additional features or steps or other embodiments incorporating different combinations of the stated features or steps.

Where in the present disclosure two or more elements are referred to as being "in fluid communication", it is meant that a fluid such as a gas or liquid or mixture thereof can flow between the elements, in one or both directions. The fluid communication may be achieved, for example, by means of a gas line, tube, pipe, inlet, outlet, or any combination thereof. The fluid communication may be interruptible; for example, a valve or other flow control element may be present.

In this disclosure, any two numbers of a variable can constitute a workable range of the variable, and any ranges indicated may include or exclude the endpoints. Additionally, any values of variables indicated (regardless of whether they are indicated with "about" or not) may refer to precise values or approximate values and include equivalents, and may refer to average, median, representative, majority, etc. in some embodiments. Further, in this disclosure, the terms "including," "constituted by" and "having" can refer independently to "typically or broadly comprising," "comprising," "consisting essentially of," or "consisting of" in some embodiments. In this disclosure, any defined meanings do not necessarily exclude ordinary and customary meanings in some embodiments. In some cases, percentages indicate herein can be relative or absolute percentages.

A number of example materials are given throughout the embodiments of the current disclosure, it should be noted that the chemical formulas given for each of the example materials should not be construed as limiting and that the non-limiting example materials given should not be limited by a given example stoichiometry.

In the specification, it will be understood that the term "on" or "over" may be used to describe a relative location relationship. Another element, film or layer may be directly on a mentioned layer, or another layer (an intermediate layer) or element may be intervened therebetween, or a layer may be disposed on a mentioned layer but not completely cover a surface of the mentioned layer. Therefore, unless the term "directly" is separately used, the term "on" or "over" will be construed to be a relative concept. Similarly to this, it will be understood the term "under", "underlying", or "below" will be construed to be relative concepts.

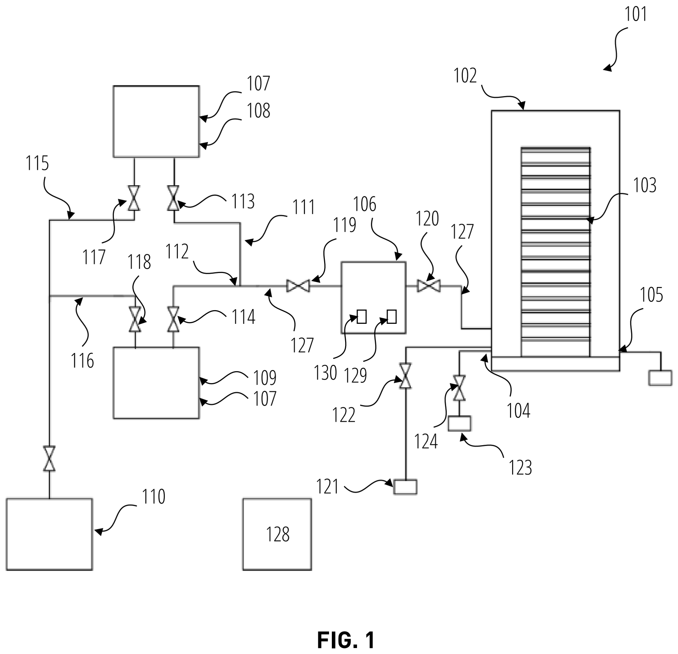

Referring to FIG. 1, a semiconductor processing apparatus 101 according to embodiments of the present invention is shown. The semiconductor processing apparatus 101 comprises a process chamber 102 which is configured to receive a plurality of substrates 103 for processing. The process chamber 102 comprises at least one process chamber gas flow inlet 104for allowing a gas to enter the process chamber 102 and at least one process chamber gas exhaust outlet 105 for removing gas from the process chamber 102. The semiconductor processing apparatus 101 comprises an accumulator vessel 106 in fluid communication with the process chamber 102, the accumulator vessel 106 being configured to store precursor in gas form. The semiconductor processing apparatus 101 comprises at least two solid state precursor storage vessels, each being in fluid communication with the accumulator vessel 106 so as to allow provision of precursor in gas form to the accumulator vessel 106. Each of the at least two solid state precursor storage vessels 107 are configured to cause said solid state precursor to be converted to gas phase. Although in Figure 1 two solid state precursor storage vessels 107 are illustrated, it will be understood by the skilled person that more than two solid state precursor storage vessels may be present, for example three or four or more. In the following, a first solid state precursor storage vessel 108 and a second solid state precursor storage vessel 109 are described, without restricting the present invention to embodiments having exactly two solid state precursor storage vessels 107.

The precursor may be a precursor which may be stored in the solid state for long time periods without significant decomposition. When the precursor is required to be transported between components of the semiconductor processing apparatus 101, the precursor may be converted to the gas state; for example, when supplying precursor from the solid state precursor storage vessels 107 to the accumulator vessel 106. The precursor may be stored for relatively short periods of time in gas form, for example in the accumulator vessel 106 before being delivered to the process chamber 102, or in the solid state precursor storage vessels 107 before delivery to the accumulator vessel 106.

Each of the at least two solid state precursor storage vessels 107 may be in fluid communication with a bulk precursor supply 110 for providing a precursor in gas form. The bulk precursor supply 110 may supply precursor in gas state on demand to the solid state precursor storage vessels 107. The bulk precursor supply 110 may store precursor in solid state. The bulk precursor supply 110 may be a sub-fab supply for supplying precursor to multiple semiconductor processing apparatuses 101.

The semiconductor processing apparatus 101 may comprise a first gas line 111 for providing a fluidic connection between a first solid state precursor storage vessel 108 of the at least two solid state precursor storage vessels 107 and the accumulator vessel 106, and a second gas line 112 for providing a fluidic connection between a second solid state precursor storage vessel 109 of the at least two solid state precursor storage vessels 107 and the accumulator vessel 106. The first gas line 111 may include a first gas flow control valve 113 for controlling a flow of precursor gas in the first gas line 111. The second gas line 112 may include a second gas flow control valve 114 for controlling a flow of precursor gas in the second gas line 112. The gas flow control valves 113, 114 may be, for example, valves having only an open position and a closed position, or valves which may be configured to allow a specific amount of gas flow by being neither fully open nor fully closed. The first gas line 111 may include a first gas flow measurement device for measuring a rate of gas flow in the first gas line 111. The second gas line 112 may include a second gas flow measurement device for measuring a rate of gas flow in the second gas line 112.

By providing separate gas lines through which the gas flow is controllable using respective gas flow control valves, the supply of precursor to the accumulator vessel 106 from each of the at least two solid state precursor storage vessels 107 can be controlled.

The semiconductor processing apparatus 101 may comprise a third gas line 115 for providing a fluidic connection between the bulk precursor supply 110 and the first solid state precursor storage vessel 108. The third gas line 115 may include a third gas flow control valve 117 for controlling a flow of precursor gas in the third gas line 115. The semiconductor processing apparatus 101 may comprise a fourth gas line 116 for providing a fluidic connection between the bulk precursor supply 110 and the second solid state precursor storage vessel 109. The fourth gas line 116 may include a fourth gas flow control valve 118 for controlling a flow of precursor gas in the fourth gas line 116.

By providing separate gas lines through which the gas flow is controllable using respective gas flow control valves, the supply of precursor from the bulk precursor supply 110 to the solid state precursor storage vessels 107 can be individually controlled. As will be discussed in more detail hereinafter, this allows for one (or more) of the at least two solid state precursor vessels to supply gas precursor to the accumulator vessel 106 while at the same time one (or more) of the at least two solid state precursor storage vessels 107 is receiving gas precursor from the bulk precursor supply 110.

The semiconductor processing apparatus 101 may comprise a fifth gas flow control valve 119 disposed upstream of the accumulator vessel 106 and configured to control a gas flow into the accumulator vessel 106 from any of the at least two solid state precursor storage vessels 107. The fifth gas flow control valve 119 may in some embodiments not be provided and the third gas flow control valve 117 and fourth gas flow control valve 118 may be used for controlling gas from into the accumulator vessel 106 from the solid state precursor storage vessels 107. The semiconductor processing apparatus 101 may comprise a sixth gas flow control valve 120 disposed between the accumulator vessel 106 and the process chamber 102 for controlling a gas flow from the accumulator vessel 106 into the process chamber 102. The semiconductor processing apparatus 101 may comprise heating means for heating the fifth gas flow control valve 119. The semiconductor processing apparatus 101 may comprise heating means for heating the sixth gas flow control valve 120.

Gas flow control valves used in the semiconductor processing apparatus according to embodiments of the present invention preferably have a high flow conductance, to minimise flow restrictions caused by passage through said valves, and a high operating temperature to ensure any condensation of gas at the valves is minimal.

The semiconductor processing apparatus 101 may comprise a second process gas source 121 in fluid communication with the process chamber 102, for providing a second process gas to the process chamber 102. The second process gas is different to the precursor. A second process gas flow control valve 122 may be provided between the second process gas source 121 and the process chamber 102 for controlling flow of the second process gas to the process chamber 102. The semiconductor processing apparatus 101 may comprise a purge gas source 123 in fluid communication with the process chamber 102, for providing a purge gas to the process chamber 102. A purge gas flow control valve 124 may be provided between the purge gas source 123 and the process chamber 102 for controlling flow of the purge gas to the process chamber 102.

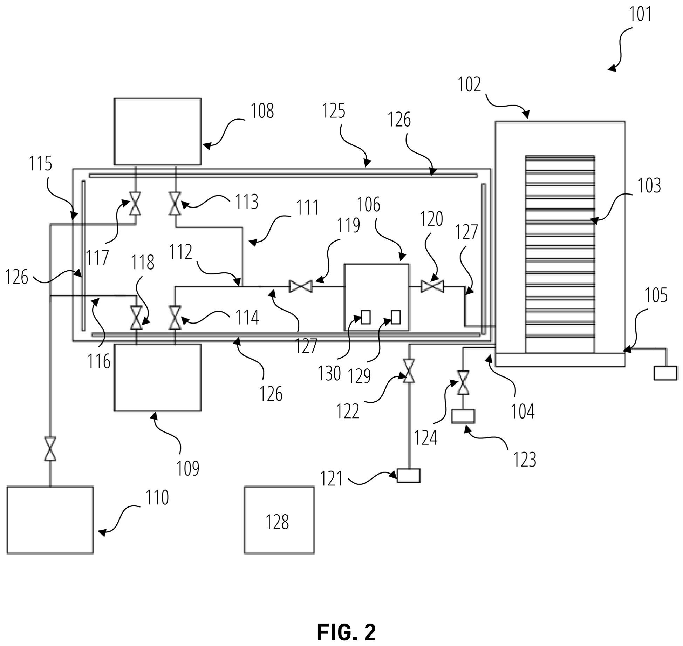

Referring to FIG. 2, the semiconductor processing apparatus 101 may comprise an enclosure 125 for enclosing at least a part of the semiconductor processing apparatus located between the bulk precursor supply 110 and the process chamber 102. This can help to improve temperature uniformity in the precursor supply line. The enclosure 125 comprises an enclosure heater 126 for heating the interior of the enclosure 125. In some embodiments, the enclosure 125 may enclose at least one gas flow control valve, for example at least one and preferably all of the first, second, third, fourth, fifth, and sixth gas flow control valves. The respective gas lines in fluid communication with the one or more gas flow control valves enclosed by the enclosure may be located outside of the enclosure and may be heated using heating jackets.

In some embodiments, the enclosure 125 encloses at least a part of the first, second, third, fourth, and fifth gas lines and preferably encloses substantially all of the first, second, third, fourth, and fifth gas lines. In some embodiments, the enclosure 125 encloses the accumulator vessel 106 along with the first, second, third, fourth, fifth, and sixth gas flow control valves.

The enclosure heater 126 may be located inside the enclosure 125. The enclosure heater 126 may be integrated into one or more walls of the enclosure 125. The enclosure heater 126 may comprise multiple heating elements located inside and along the walls of the enclosure 125.

Referring now to both FIG. 1 and FIG. 2, the semiconductor processing apparatus 101 may comprise a fifth gas line 127 providing a fluid connection between the solid state precursor storage vessels 107 and the process chamber 102 and the accumulator vessel 106 may be disposed in the fifth gas line 127. The fifth gas line 127 may comprise the fifth gas flow control valve 119 and the sixth gas flow control valve 120. In some embodiments, the accumulator vessel 106 may be a container having an input in fluid communication with the fifth gas line 127 and an output in fluid communication with the sixth gas line. In some embodiments, the accumulator vessel 106 may be a part of the fifth gas line 127 between the fifth gas flow control valve 119 and the sixth gas flow control valve 120, that is, a separate container may not be provided. In such embodiments, the part of the fifth gas line 127 which is between the fifth gas flow control valve 119 and the sixth gas flow control valve 120 may be located inside the enclosure 125, if the enclosure 125 is provided.

In some embodiments, at least part of and preferably a substantial part of the fifth gas line 127 is located inside the enclosure 125. In some embodiments, the enclosure 125 encloses as much as possible of the first gas line 111, the second gas line 112, and the fifth gas line 127, such that a minimal part of the respective gas lines is outside the enclosure 125, at points where the respective gas lines connect to, e.g. the solid state precursor storage vessels, the accumulator vessel 106, the process chamber 102.

The accumulator vessel 106 may comprise a pressure transducer 129 for measuring a pressure of precursor gas in the accumulator vessel 106 and an accumulator thermocouple 130 for measuring a temperature of the precursor gas in the accumulator vessel 106. The accumulator thermocouple 130 may be located in a thermo-well extending from the top side of the accumulator vessel 106 to the vicinity of the centre of the interior volume of the accumulator vessel 106. The pressure transducer 129 may be located in the inlet line to the accumulator vessel 106, that is, in the fifth gas line 127 upstream of the accumulator vessel 106. The pressure transducer 129 may have a connection to the fifth gas line 127 which is inside the enclosure 125, in embodiments wherein the enclosure 125 is provided.

The semiconductor processing apparatus 101 may comprise respective heaters for the gas flow control valves which control gas lines through which precursor gas flows. The heaters may be individually controllable. By heating a gas flow control valve through which precursor gas flows to a temperature above a deposition temperature of the precursor gas, deposition of precursor on the gas flow control valve can be prevented, which can avoid clogging of the gas flow control valves. A gas flow control valve may be heated continuously using its respective heater, or may be heated only when in an open state for allowing precursor gas to flow therethrough.

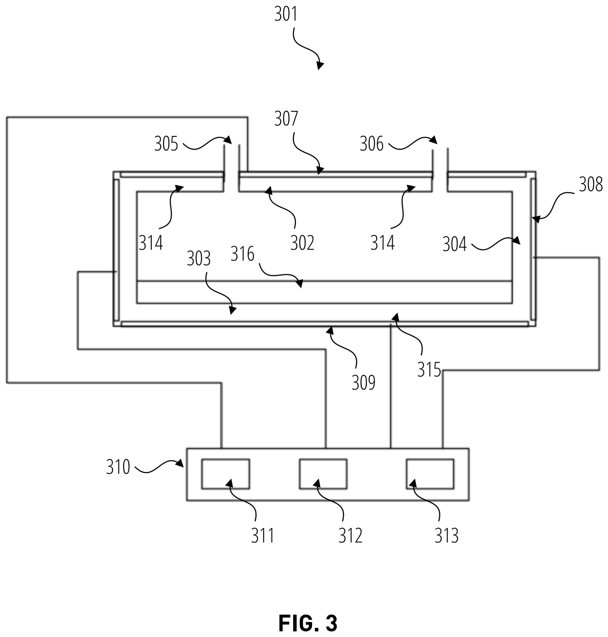

Referring to FIG. 3, an example of a solid state precursor storage vessel 301 which may be comprised in the semiconductor processing apparatus 101 according to embodiments of the present invention is shown. The solid state precursor storage vessel 301 has a top wall 302, a bottom wall 303, and a side wall 304; a gas inlet port 305, and a gas outlet port 306. The gas inlet port 305 may be provided in the top wall 302. The gas outlet port 306 may be provided in the top wall 302. The gas inlet port 305 provides a conduit for precursor gas to flow into the solid state precursor storage vessel 301 and may be in fluid communication with a bulk precursor supply. The gas outlet port 306 provides a conduit for precursor gas to flow out of the solid state precursor storage vessel 301 and may be in fluid communication with an accumulator vessel.

The solid state precursor storage vessel 301 comprises a top wall heater 307 for heating the top wall 302, a side wall heater 308 for heating the side wall 304, and a bottom wall heater 309 for heating the bottom wall 303. The top wall heater 307, the side wall heater 308, and the bottom wall heater 309 are individually controllable. The solid state precursor storage vessel 301 may comprise a solid state precursor storage vessel controller 310 comprising a top wall heater controller 311, a side wall heater controller 312, and a bottom wall heater controller 313, each of which are independently operable.

The top wall heater controller 311 may be configured to, during supply of precursor to the solid state precursor storage vessel 301 from the bulk precursor supply, maintain the top wall 302 of the solid state precursor storage vessel 301 at a temperature above a deposition temperature of the precursor gas, so as to avoid deposition of precursor on the top wall 302. The side wall heater controller 312 may be configured to, during supply of precursor to the solid state precursor storage vessel 301 from the bulk precursor supply, maintain the side wall 304 of the solid state precursor storage vessel 301 at a temperature above a deposition temperature of the precursor gas, so as to avoid deposition of precursor on the side wall 304. The bottom wall heater controller 313 may be configured to, during supply of precursor to the solid state precursor storage vessel 301 from the bulk precursor supply, maintain the bottom wall 303 of the solid state precursor storage vessel 301 at a temperature at or below a deposition temperature of the precursor gas so as to cause deposition of the precursor on the bottom wall 303.

The top wall heater 307 may be considered to be a heater for heating a first section 314 of the solid state precursor storage vessel 301 close to the gas inlet port 305 and/or the gas outlet port 306 and the bottom wall heater 309 may be considered to be a heater for heating a second section 315 of the solid state precursor storage vessel 301 further from the gas inlet port 305. By providing separately controllable heaters for the first section 314 and for the second section 315, the temperatures of these sections can be controlled so as to promote deposition of precursor at or near the second section 315 and to discourage deposition of precursor at or near the first section 314. For example, during refill of the solid state precursor storage vessel 301 with gas precursor, the bottom wall heater 309 may be controlled (e.g. Using the bottom wall heater controller 313) to maintain the bottom wall 303 at a temperature below the deposition temperature of the precursor, and the top wall heater 307 may be controlled (e.g. Using the top wall heater controller 311) to maintain the top wall 302 at a temperature above the deposition temperature of the precursor. The solid state precursor storage vessel 301 is illustrated in FIG. 3 as containing solid state precursor 316, but may at certain points in time be empty of solid state precursor 316, for example before the first filling or between refilling processes.

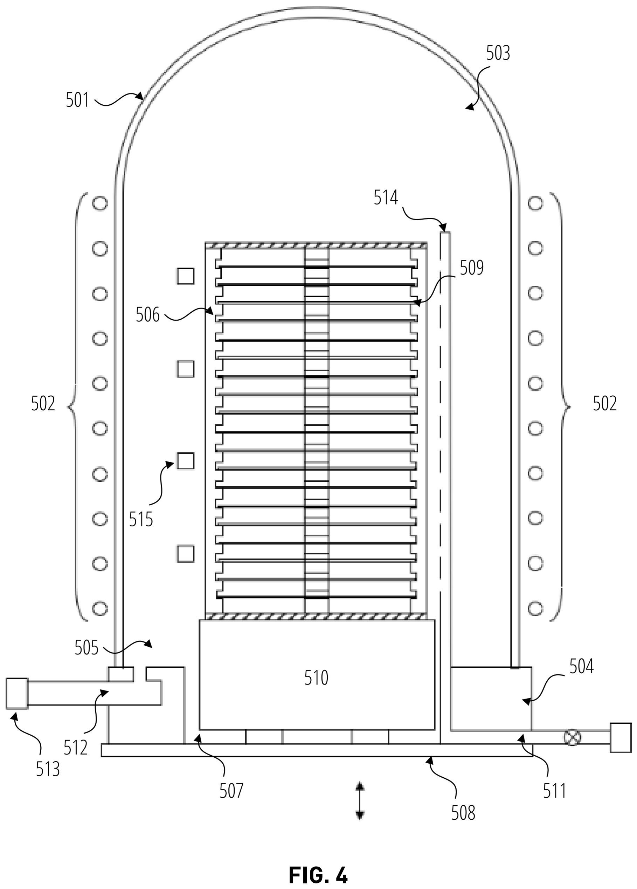

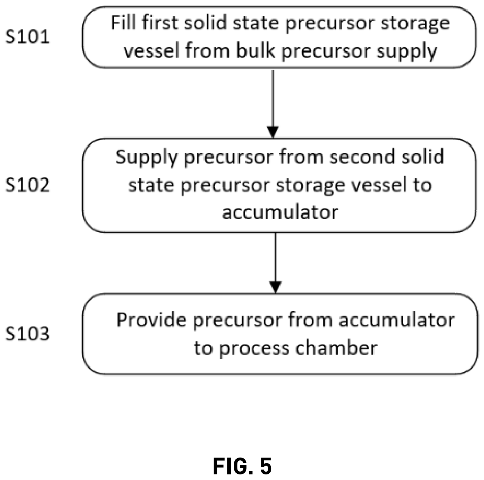

Referring to FIG. 4, an example of a process chamber 501 which may be comprised in the semiconductor processing apparatus 101 is shown in more detail. The present invention is not limited to semiconductor processing apparatus 101 comprising the specific process chamber 501 shown in FIG. 5 and other types of process chamber 501 with similar or different features may be used instead of the process chamber 501 shown in FIG. 5. The process chamber 501 may be be generally bell jar shaped. The process chamber may be surrounded by heating means, such as one or more thermally resistive heating coils 502 powered by an electrical power supply (not shown). The heating means provides heat to the process chamber which subsequently causes the interior volume 503 of the process chamber to be heated. The process chamber may be made of quartz, silicon carbide, silicon or another suitable heat resistant material.

The process chamber may be supported at its lower end on a flange 504 for partially closing an open end 505 of the process chamber 501. A substrate boat 506 may enter and/or exit the process chamber via a central furnace opening 507 provided in the flange 504. A vertically movably arranged door 508 may be configured to close off the central furnace opening 507 and may be configured to support the substrate boat 506. The substrate boat 506 is configured to support a plurality of substrates 509. The substrate boat 506 may sometimes be inserted into the process chamber while empty i.e. not supporting any substrates 509. The substrates 509 may in some cases be dummy wafers which are not intended to be used for further manufacture. The substrate boat 506 may support, for example, 100 substrates, 120 substrates, 150 substrates, 170 substrates, or greater than 170 substrates.

The door 508 may be provided with a pedestal 510. The pedestal 510 may be rotated to have the substrate boat 506 rotating. The process chamber 501 comprises at least one process chamber gas flow inlet 511 for providing a flow of gas into the process chamber. The process chamber gas flow inlet 511 may be at least partially comprised in the flange 504. The flange 504 may comprises a process chamber gas exhaust outlet 512 to remove gas from the process chamber. The process chamber gas exhaust outlet 512 may be connected to a vacuum pump 513.

The process chamber gas flow inlet 511 may be configured to provide a flow of one or more of a process gas (e.g. precursor gas), a purge gas, and a cleaning gas into the process chamber. In some embodiments, separate process chamber gas flow inlets 511 may be provided for each of one or more process gases and a purge gas and optionally a cleaning gas.

The process chamber gas flow inlet 511 may be provided with an injector 514 constructed and arranged within the process chamber to extend vertically into the inner space of the process chamber along the wall of the process chamber towards the higher end. The injector 514 may comprise injector openings to inject gas towards the substrates 509. In some embodiments, the injector 514 may comprise multiple injector openings distributed along a vertical direction of the injector. In some embodiments, the injector 514 may comprise a single opening at a top end of the injector 514, being opposite to the end of the injector 514 which connects with the process chamber gas flow inlet 511. In some embodiments, the injector 514 is not provided and the gas flows upwards from the process chamber gas flow inlet 511 without its flow being directed by an injector. In some embodiments, a process chamber gas flow inlet 511 provided with an injector may be provided in addition to an additional process chamber gas flow inlet 511 which is not connected to an injector.

One or more thermocouples 515 may be provided within the process chamber for measuring the temperature inside the process chamber 501. The thermocouples 515 may be provided each within a different heating zone of the process chamber 501 corresponding to a respective heating coil 502.

Referring again to FIG. 1, the semiconductor processing apparatus 101 may comprise a controller 128 configured to control one or more elements of the semiconductor processing apparatus 101. For example, the controller 128 may be configured to control a state of the gas flow control valves, such as the first gas flow control valve 113, the second gas flow control valve 114, the third gas flow control valve 117, the fourth gas flow control valve 118, the fifth gas flow control valve 119, the sixth gas flow control valve 120, the purge gas flow control valve 124, the second process gas flow control valve 122, and/or their respective heaters. The controller 128 may be configured to control the top wall heater 307, the side wall heater 308, the bottom wall heater 309 of the solid state precursor storage vessels 301, 107. The top wall heater controller 311 may be comprised in the controller 128. The side wall heater controller 312 may be comprised in the controller 128. The bottom wall heater controller 313 may be comprised in the controller 128. The controller 128 may be configured to control the heating coils 502 of the process chamber 102. The controller 128 may be configured to receive data from various sensors comprised in the semiconductor processing apparatus 101, for example the thermocouples 515 of the process chamber 102, 501, the pressure transducer 129, the accumulator thermocouple 130, the differential pressure transducer (described in more detail hereinafter), and to control one or more elements of the semiconductor processing apparatus 101 based on received data. The controller 128 may store, in a memory, a series of instructions for carrying out a method(s) according to embodiments of the present invention, and may load such instructions into a processor configured to execute the instructions so as to carry out the method(s).

Referring to FIG. 5, a flow chart of a method according to embodiments of the present invention of providing the precursor gas to the process chamber 102 of the semiconductor processing apparatus 101 is shown. The method comprises the steps of causing a first solid state precursor storage vessel 108 of the at least two solid state precursor storage vessels 107 to receive a precursor in gas form and to convert said precursor to a solid state (step S101), causing a second solid state precursor storage vessel 109 of the at least two solid state precursor storage vessels 107 to convert solid state precursor stored therein to gas form and to provide precursor in gas form to the accumulator vessel 106 (step S102), and causing a precursor gas to be provided to the process chamber 102 from the accumulator vessel 106 (step S103). Step S101 and step S102 are preferably performed simultaneously.

In step S101, causing the first solid state precursor storage vessel 108 to receive a precursor in gas form may comprise causing a precursor gas to be provided to the first solid state precursor storage vessel 108 from the bulk precursor supply 110. Step S101 may comprise setting the third gas flow control valve 117 to an open state. In step S101, the second solid state precursor storage vessel 109 may not be receiving precursor gas from the bulk precursor supply 110, and so step S101 may comprise setting the fourth gas flow control valve 118 to a closed state.

In step S101, causing the first solid state precursor storage vessel 108 to convert the received precursor in gas form to solid state may comprise causing a temperature of a wall of the first solid state precursor storage vessel 108 to be maintained at a temperature which is less than a deposition temperature of the precursor. This causes precursor to condense on a wall of the first solid state precursor storage vessel 108. This deposited precursor can then be stored in the solid state until it is required to be provided to the accumulator vessel 106 in gas state. By storing the precursor in the first solid state precursor storage vessel 108 in the solid state, the time for which the precursor can be stored without significant decomposition is extended considerably in comparison to storing the precursor in gas state. By providing the precursor to the first solid state precursor storage vessel 108 in gas form, issues of clogging or contamination associated with provision of precursor in powder or liquid format can be avoided. Step S101 may comprise causing a temperature of a region of a wall of the first solid state precursor storage vessel 108, such region being close to a gas inlet and/or a gas outlet of the first solid state precursor storage vessel 108, to be maintained at a temperature above a deposition temperature of the precursor. This can help to avoid deposition of precursor in and/or around the inlet and/or outlet, reducing the chance of flow restriction at the inlet and/or outlet. The first solid state precursor storage vessel 108 may therefore comprise one or more individually controllable heaters configured to heat respective areas of the walls of the first solid state precursor storage vessel 108.

In step S102, causing the second solid state precursor storage vessel 109 to convert solid state precursor stored therein to gas form may comprise causing a temperature of the walls of the second solid state precursor storage vessel 109 to be heated to a temperature above a sublimation temperature of the precursor in solid state.

Step S101 and step S102 may be performed substantially simultaneously, that is, while the first solid state precursor storage vessel 108 is undergoing a refill process by receiving and converting gas state precursor to solid state, the second solid state precursor storage vessel 109 is sublimating and providing gas precursor to the accumulator vessel 106. The solid state precursor storage vessels 107 may subsequently switch roles, that is, the first solid state precursor storage vessel 108 sublimates and provides gas precursor to the accumulator vessel 106 while the second solid state precursor storage vessel 109 receives and converts gas precursor to solid state. This allows the supply of precursor to the accumulator vessel 106 to be continuously available, which increases the throughput of the semiconductor processing apparatus 101.

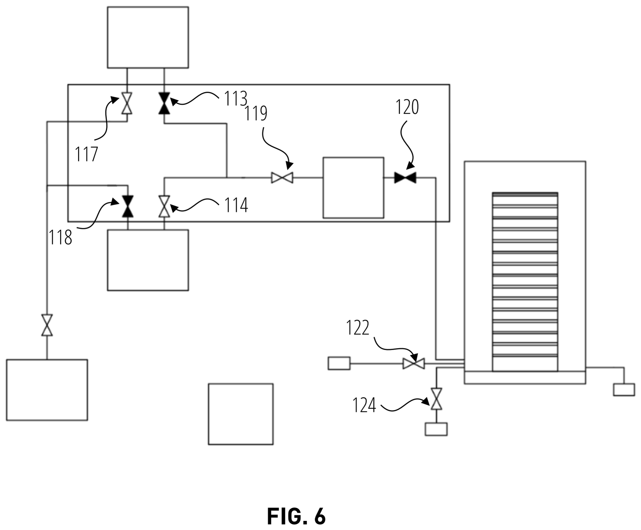

The gas flow control valve states during steps S101 and S102 are shown in FIG. 6. During supply of precursor to the first solid state precursor storage vessel 108 from the bulk precursor supply 110, the first solid state precursor storage vessel 108 does not provide precursor gas to the accumulator vessel 106, and so the first gas flow control valve 113 is set to an closed state and the third gas flow control valve 117 is set to an open state. During supply of precursor from the second solid state precursor storage vessel 109 to the accumulator vessel 106, the second solid state precursor storage vessel 109 does not receive precursor from the bulk precursor supply, and so the second gas flow control valve 114 is set to an open state and the fourth gas flow control valve 118 is set to a closed state. The fifth gas flow control valve 119, if present, is set to an open state and the sixth gas flow control valve 120, if present, may be set to a closed state. The purge gas flow control valve 124 and the second process gas flow control valve 122 may be open or closed depending on the status of the process chamber 102, for example depending on which stage of a layer deposition process is being carried out. For example, steps S101 and S102 may take place during a purge gas provision step and/or a second process gas provision step in a layer deposition process.

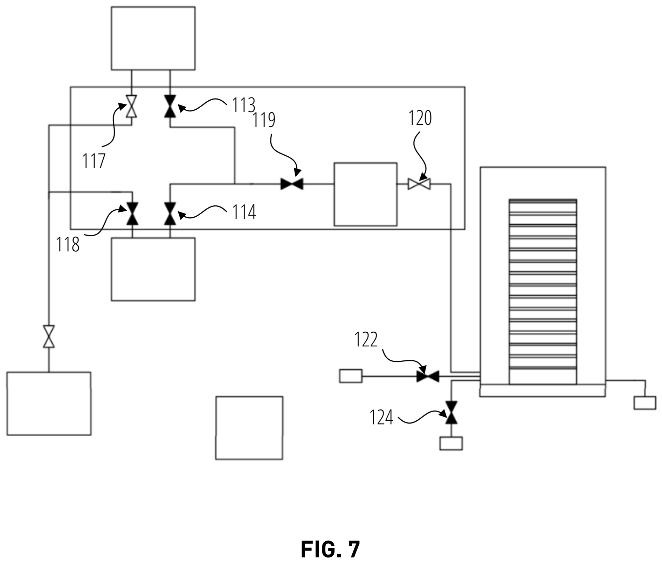

The gas flow control valve states during step S103 are shown in FIG. 7. Once a sufficient quantity of gas precursor has been accumulated in the accumulator vessel 106, the sixth gas flow control valve 120 is set to an open state and the fifth gas flow control valve 119 may be set to an open or a closed state. This allows precursor gas to flow from the accumulator vessel 106 to the process chamber 102. During step S103, the second process gas flow control valve 122 and the purge gas flow control valve 124 are closed.

After step S103 is completed, the process may be repeated, i.e. Steps S101, S102, and S103 are again performed. Steps S101, S102, and S 103 may form part of a deposition process for depositing a layer of a desired thickness on a plurality of substrates 103 in the process chamber 102. The deposition process may include a number of repetitions of steps S101, S102, and S103 followed by removal of the plurality of substrates 103 from the process chamber 102, loading of a different plurality of substrates 103 into the process chamber 102, and a further deposition process for depositing a layer of a desired thickness on the different plurality of substrates 103 comprising repetition of steps S101, S102, and S103.

The functions of the first solid state precursor storage vessel 108 and the second solid state precursor storage vessel 109 may be swapped, that is, in step S101 the second solid state precursor storage vessel 109 is caused to receive a precursor in gas form and to convert said precursor to a solid state, and in step S102 the first solid state precursor storage vessel 108 is caused to convert solid state precursor stored therein to gas form and to provide precursor in gas form to the accumulator vessel 106. This swapping of functions may take place once the quantity of precursor in the second solid state precursor storage vessel 109, being the solid state precursor storage vessel which is supplying precursor to the accumulator vessel 106, has decreased to a quantity which is not sufficient for providing a required amount of precursor gas for a required number of repetitions of step S103. For example, in some embodiments, the at least two solid state precursor storage vessels may each be positioned on a load scale to measure the amount of precursor stored therein and once the measured quantity is below a threshold value, the controller may cause the functions of the first solid state precursor storage vessel 108 and the second solid state precursor storage vessel 109 to be swapped. In some embodiments, the functions of the first solid state precursor storage vessel 108 and the second solid state precursor storage vessel 109 may be swapped automatically between deposition processes.

The first solid state precursor storage vessel 108 and the second solid state precursor storage vessel 109 may continue to exchange functions dependent on the amount of precursor remaining or between deposition processes. Depending on the amount of precursor required for depositing a layer, the functions may not be swapped between every deposition process.

In some embodiments, step S103 may comprise determining an amount of precursor provided to the process chamber 102. For example, the accumulator vessel 106 may comprise a pressure transducer 129 for measuring a pressure of precursor gas in the accumulator vessel 106 and an accumulator thermocouple 130 for measuring a temperature of the precursor gas contained in the accumulator vessel 106. Step S103 may comprise determining an amount of precursor provided to the process chamber 102 based on data received from the pressure transducer 129 and the accumulator thermocouple 130 before and/or during provision of precursor to the process chamber 102, for example by using the ideal gas law with knowledge of the inner volume of the accumulator vessel 106.

In some embodiments, in step S103, the fifth gas flow control valve 119 is closed while precursor gas is supplied to the process chamber 102, such that no precursor gas is provided to the accumulator vessel 106 while precursor gas is supplied to the process chamber 102. This can allow for a highly accurate calculation of the amount of precursor provided to the process chamber 102.

In some embodiments, in step S103, the fifth gas flow control valve 119 is open while precursor gas is supplied to the process chamber 102, allowing precursor gas to flow into the accumulator vessel 106 while precursor gas is provided to the process chamber 102. This can allow for higher quantities, or doses, of precursor gas to be provided to the process chamber 102.

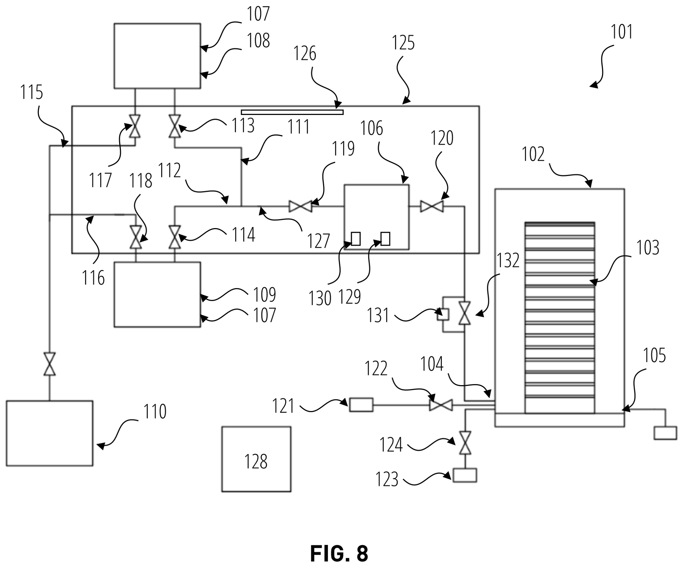

For example, referring to FIG. 8, in some embodiments, the semiconductor processing apparatus 101 may comprise an orifice valve 131 provided in the gas flow path between the accumulator vessel 106 and the process chamber 102, along with a differential pressure transducer 132 for measuring a pressure difference between a point upstream of the orifice valve 131 and a point downstream of the orifice valve 131. This allows the flow rate of the precursor gas and thereby the amount of precursor gas provided to the process chamber 102 during a certain time period to be determined.

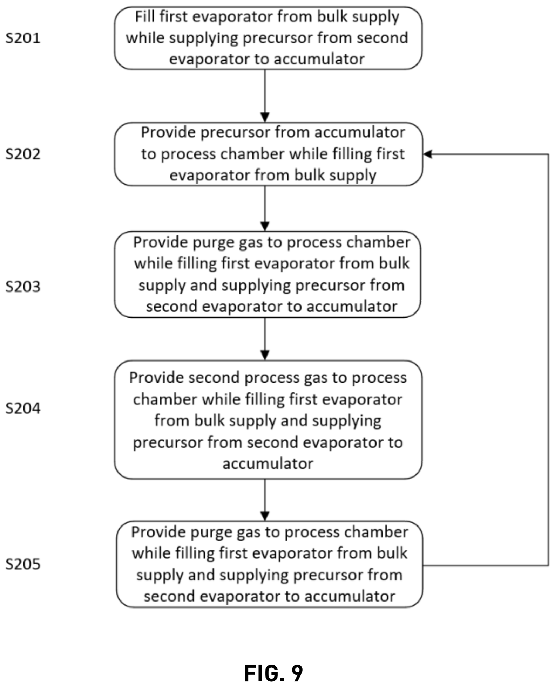

Referring to FIG. 9, a flow chart of a deposition method according to embodiments of the present invention is shown. The deposition method is carried out using a semiconductor processing apparatus 101 according to embodiments of the present invention. The deposition method comprises the following steps:

In step S201, the first solid state precursor storage vessel 108 is caused to receive gas precursor from the bulk precursor supply 110 while precursor gas is supplied from the second solid state precursor storage vessel 109 to the accumulator vessel 106. In step S201, the third gas flow control valve 117 is set to an open state and the fourth gas flow control valve 118 is set to a closed state; the first gas flow control valve 113 is set to a closed state and the second gas flow control valve 114 is set to an open state; the fifth gas flow control valve 119 may be set to an open state or a closed state and the sixth gas flow control valve 120 is set to a closed state. This step may be seen as a preparation or pre-filling step and may be performed once at the beginning of a series of repetitions of steps S202 to S205.

In step S202, precursor gas is provided from the accumulator vessel 106 to the process chamber 102 while the first solid state precursor storage vessel 108 is caused to receive gas precursor from the bulk precursor supply 110. In step S202, the third gas flow control valve 117 is set to an open state and the fourth gas flow control valve 118 is set to a closed state; the first gas flow control valve 113 is set to a closed state and the second gas flow control valve 114 may be set to an open state or a closed state; the fifth gas flow control valve 119 may be set to the same state as that of the second gas flow control valve; and the sixth gas flow control valve 120 is set to an open state. The second process gas flow control valve 122 and the purge gas flow control valve 124 are set to a closed state. By providing precursor gas to the process chamber 102, the precursor gas may react with the surface of the plurality of substrates in a self-limiting manner so as to form a layer comprising the precursor on a surface of the plurality of substrates in the process chamber 102.

In step S203, a purge gas is provided to the process chamber 102 while causing the first solid state precursor storage vessel 108 to receive gas precursor from the bulk precursor supply 110 and causing the second solid state precursor storage vessel 109 to provide gas precursor to the accumulator vessel 106. In step S203, the third gas flow control valve 117 is set to an open state and the fourth gas flow control valve 118 is set to a closed state; the first gas flow control valve 113 is set to a closed state and the second gas flow control valve 114 is set to an open state; the fifth gas flow control valve 119 is set to an open state and the sixth gas flow control valve 120 is set to a closed state. The purge gas flow control valve 124 is set to an open state and the second process gas flow control valve 122 is set to a closed state. By providing the purge gas to the process chamber 102, any precursor gas remaining in the process chamber 102 from step S202 may be removed from the process chamber 102 via the process chamber gas exhaust outlet 105.

In step S204, a second process gas is provided to the process chamber 102 while causing the first solid state precursor storage vessel 108 to receive gas precursor from the bulk precursor supply 110 and causing the second solid state precursor storage vessel 109 to provide gas precursor to the accumulator vessel 106. In step S204, the third gas flow control valve 117 is set to an open state and the fourth gas flow control valve 118 is set to a closed state; the first gas flow control valve 113 is set to a closed state and the second gas flow control valve 114 is set to an open state; the fifth gas flow control valve 119 is set to an open state and the sixth gas flow control valve 120 is set to a closed state. The purge gas flow control valve 124 is set to a closed state and the second process gas flow control valve 122 is set to an open state. By providing the second process gas to the process chamber 102, the second process gas may react with a surface of the plurality of substrates so as to form a layer comprising a component of the second process gas and the precursor on the plurality of substrates.

In step S205, a purge gas is provided to the process chamber 102 while causing the first solid state precursor storage vessel 108 to receive gas precursor from the bulk precursor supply 110 and causing the second solid state precursor storage vessel 109 to provide gas precursor to the accumulator vessel 106. In step S205, the third gas flow control valve 117 is set to an open state and the fourth gas flow control valve 118 is set to a closed state; the first gas flow control valve 113 is set to a closed state and the second gas flow control valve 114 is set to an open state; the fifth gas flow control valve 119 is set to an open state and the sixth gas flow control valve 120 is set to a closed state. The purge gas flow control valve 124 is set to an open state and the second process gas flow control valve 122 is set to a closed state. By providing the purge gas to the process chamber 102, any second process gas remaining in the process chamber 102 from step S204 may be removed from the process chamber 102 via the process chamber gas exhaust outlet 105.

The method may comprise repeating steps S202 to S205 until a layer of a desired thickness is formed on the plurality of substrates 103 in the process chamber 102. The method may comprise, once the layer of desired thickness has been formed on the plurality of substrates 103 in the process chamber 102, performing a substrate swap procedure comprising cooling the process chamber 102 to an unloading temperature, removing the plurality of substrates 103 from the process chamber 102, unloading the plurality of substrates 103 from the substrate boat, loading a different plurality of substrates 103 into the substrate boat, loading the substrate boat into the process chamber 102, pumping down the process chamber 102, stabilising the temperature of the process chamber 102 and repeating steps S201 to S205 to deposit a layer of required thickness onto the different plurality of substrates 103. Step S201 may take place during the substrate swap procedure.

The method may comprise monitoring the quantity of precursor in the solid state precursor storage vessel which is supplying the accumulator vessel 106, for example using load scales, and swapping the functions of the first solid state precursor storage vessel 108 and the second solid state precursor storage vessel 109 once the quantity is below a threshold value. The controller 128 may be configured to carry out such monitoring and control, for example by receiving measurements from the load scales, comparing the received measurements with a threshold value, and, if the received measurement is below the threshold value, causing the functions of the first solid state precursor storage vessel 108 and the second solid state precursor storage vessel 109 to be swapped, for example by controlling gas flow control valves and heaters of the solid state precursor storage vessels.

The precursor may comprise, for example, molybdenum oxychloride, hafnium chloride, molybdenum chloride. The second process gas may comprise, for example, hydrogen, ammonia, ozone, water vapour. The purge gas may comprise, for example, nitrogen, argon. In some embodiments, the precursor comprises molybdenum oxychloride, the second process gas comprises ammonia, and the purge gas comprises hydrogen. In some embodiments, the precursor comprises molybdenum oxychloride, the second process gas comprises hydrogen, and the purge gas comprises argon.

The method may comprise, before step S201, providing a plurality of substrates in a substrate boat in the semiconductor processing apparatus 101.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figures, the invention not being limited to any particular embodiment(s) disclosed.

## Claims

1. A semiconductor processing apparatus comprising:
a process chamber configured to receive a plurality of substrates;
an accumulator vessel in fluid communication with the process chamber, configured to store a precursor in gas form; and
at least two solid state precursor storage vessels, each being configured to receive a precursor in gas form, to cause said received gas form precursor to be converted to a solid state inside the respective solid state precursor storage vessel, and to cause said solid state precursor to be converted to gas phase;
wherein each of the at least two solid state precursor storage vessels are in fluid communication with the accumulator vessel so as to allow provision of precursor in gas form to the accumulator vessel.

2. The semiconductor processing apparatus of claim 1 wherein each of the at least two solid state precursor storage vessels is in fluid communication with a bulk precursor supply for providing a precursor in gas form.

3. The semiconductor processing apparatus of claim 1 or 2, wherein each of the at least two solid state precursor storage vessels comprises a respective heater.

4. The semiconductor processing apparatus of any one of claims 1 to 3, wherein each of the at least two solid state precursor storage vessels comprises a respective gas inlet port configured to conduct a precursor in gas form into the respective solid state precursor storage vessel.

5. The semiconductor processing apparatus of any one of claims 1 to 4, further comprising:
a first gas line for providing a fluidic connection between a first solid state precursor storage vessel of the at least two solid state precursor storage vessels and the accumulator vessel;
a second gas line for providing a fluidic connection between a second of the at least two solid state precursor storage vessels and the accumulator vessel;
a first gas flow control valve disposed in the first gas line and a second gas flow control valve in the second gas line; and
a controller configured to cause the first gas flow control valve to be set to a closed state while substantially simultaneously causing the second gas flow control valve to be set to an open state.

6. The semiconductor processing apparatus of any one of claims 1 to 5, further comprising:
a third gas line for providing a fluidic connection between a bulk precursor supply for providing a precursor in gas form and a first of the at least two solid state precursor storage vessels;
a fourth gas line for providing a fluidic connection between the bulk precursor supply and a second of the at least two solid state precursor storage vessels;
a third gas flow control valve disposed in the third gas line and a fourth gas flow control valve in the fourth gas line; and
a controller configured to cause the third gas flow control valve to be set to an open state while substantially simultaneously causing the fourth gas flow control valve to be set to a closed state.

7. The semiconductor processing apparatus of claim 6, further comprising a third gas flow control valve heater for heating the third gas flow control valve and a fourth gas flow control valve heater for heating the fourth gas flow control valve.

8. The semiconductor processing apparatus of any one of claims 1-7, wherein the accumulator vessel comprises an accumulator vessel heater.

9. The semiconductor processing apparatus of any one of claims 1-8, comprising a fifth gas flow control valve disposed upstream of the accumulator vessel and configured to control a gas flow into the accumulator vessel from any of the at least two solid state precursor storage vessels; and a fifth gas flow control valve heater.

10. The semiconductor processing apparatus of any one of claims 1-9, comprising a sixth gas flow control valve disposed downstream of the accumulator vessel and configured to control a gas flow from the accumulator vessel into the process chamber; and a sixth gas flow control valve heater.

11. The semiconductor processing apparatus of any one of claims 1 to 10, comprising an enclosure for enclosing at least a part of the semiconductor processing apparatus located between a bulk precursor supply and the process chamber, and an enclosure heater for heating an interior of the enclosure.

12. A method of providing a precursor gas to a process chamber of a semiconductor processing apparatus, the semiconductor processing apparatus comprising a process chamber configured to receive a plurality of substrates;
an accumulator vessel in fluid communication with the process chamber, configured to store a precursor in gas form; and
at least two solid state precursor storage vessels, each being configured to receive a precursor in gas form, to cause said received gas form precursor to be converted to a solid state inside the respective solid state precursor storage vessel, and to cause said solid state precursor to be converted to gas phase;
wherein each of the at least two solid state precursor storage vessels are in fluid communication with the accumulator vessel so as to allow provision of gas phase precursor to the accumulator vessel;
wherein the method comprises:
i) causing a first solid state precursor storage vessel of the at least two solid state precursor storage vessels to receive a precursor in gas form and to convert said precursor to a solid state;
ii) causing a second solid state precursor storage vessel of the at least two solid state precursor storage vessels to convert solid state precursor to gas form and to provide precursor in gas form to the accumulator vessel; and
iii) causing a precursor gas to be provided to the process chamber from the accumulator vessel.

13. The method of claim 12, wherein steps i) and ii) are performed substantially simultaneously.

14. The method of claim 12 or 13, wherein step ii) and step iii) do not overlap substantially in time.

15. The method of any one of claims 12 to 14, further comprising, after step iii), causing the second solid state precursor storage vessel to receive a precursor in gas form and to convert said precursor to a solid state, and causing the first solid state precursor storage vessel to convert solid state precursor to gas form and to provide precursor in gas form to the accumulator vessel.

16. The method of any one of claims 12 to 15, wherein causing a solid state precursor storage vessel to receive a precursor in gas form comprises causing a bulk precursor supply to provide the precursor in gas form to the solid state precursor storage vessel.

17. The method of any one of claims 12 to 16, wherein the accumulator vessel comprises a pressure transducer and a thermocouple, wherein step iii) comprises determining an amount of precursor provided to the process chamber based on data received from the pressure transducer and thermocouple.

18. The method of any one of claims 12 to 17, wherein step iii) comprises closing an input port of the accumulator vessel so that no further precursor gas is provided to the accumulator vessel while precursor gas is supplied to the process chamber.

19. The method of any one of claims 12 to 17, wherein step iii) comprises leaving open an input port of the accumulator vessel so that precursor gas is provided to the accumulator vessel while precursor gas is supplied to the process chamber.

20. A method of forming a layer on a plurality of substrates using the semiconductor processing apparatus of any one of claims 1 to 11, the method comprising the steps of:
causing a first solid state precursor storage vessel of the at least two solid state precursor storage vessels to receive gas precursor from a bulk precursor supply while supplying precursor from a second solid state precursor storage vessel of the at least two solid state precursor storage vessels to the accumulator vessel;
providing precursor from the accumulator vessel to the process chamber while causing the first solid state precursor storage vessel to receive gas precursor from the bulk precursor supply;
providing a purge gas to the process chamber while causing the first solid state precursor storage vessel to receive gas precursor from the bulk precursor supply and causing the second solid state precursor storage vessel to provide gas precursor to the accumulator vessel;
providing a second process gas to the process chamber while causing the first solid state precursor storage vessel to receive gas precursor from the bulk precursor supply and causing the second solid state precursor storage vessel to provide gas precursor to the accumulator vessel; and
providing a purge gas to the process chamber while causing the first solid state precursor storage vessel to receive gas precursor from the bulk precursor supply and causing the second solid state precursor storage vessel to provide gas precursor to the accumulator vessel.

21. The semiconductor processing apparatus of any one of claims 1 to **11** or the method according to any one of claims 12 to 19, wherein the precursor comprises molybdenum.
